# EUROPEAN PATENT APPLICATION

(11) **EP 3 023 990 A1**
(43) Date of publication of application: **25.05.2016**
(21) Application number: 14194036.1
(22) Date of filing: 20.11.2014
(51) Int. Cl.: G11C 16/16

(54) **Multi independent page erase**

(71) Applicant: NXP B.V., 5656 AG Eindhoven (NL)
(72) Inventor: Storms, Maurits, Redhill, Surrey RH1 1SH (GB); Ostertun, Soenke, Redhill, Surrey RH1 1SH (GB)
(74) Representative: Hardingham, Christopher Mark

(57) **Abstract**

Embodiments of a system (200) to perform an erase operation on a memory device (120) include a storage device (134) and a flash memory device including a flash memory controller (128). The storage device (134) is configured to store a list of multiple pages to be erased from a flash memory device. The list includes two or more independent pages residing on different erase blocks on the flash memory device. The flash memory is configured to select at least two or more independent pages on the list of multiple pages to be erased from the flash memory device and perform an erase operation erasing the selected at least two or more independent pages on the list of multiple pages to be erased from the flash memory device.

## Description

### Field

This invention relates to erasing operations on a flash memory device.

### Background

Flash memory is a non-volatile electronic computer storage medium which may be electrically erased and reprogrammed. Erasing data in a non-volatile memory may be done with a certain pre-defined and fixed granularity of the amount of data to be erased. Flash memories may allow page erase and/or sector/block erase where the sector or block consists of a fixed number of predefined pages, which may be grouped closely together.

A system to erase a non-predefined (neither amount nor location) group of independent pages allows for many advances that can save time and power, and reduce program/erase activity. Such a scheme allows the erasure of many independent pages at the same time in the background of erasing one single page. This can be useful in a system where re-trimming is applied as a means for endurance enhancement via dedicated data management, as this involves multiple erase cycles per page.

Such a system may serve other purposes to reduce the program/erase activity in a system to save time and/or power. The system also allows scrambling of a logical sector randomly over the physical matrix while still being able to erase the full logical sector at the same time. Such a system may be advantageous for security purposes allowing the scrambling of a logical sector on a die to die basis. In addition, such a system may seamlessly interact with the page and block/sector erase of various systems.

Programming and erasing data can take up significant time in certain applications (e.g., in a non-volatile memory). Either a part of or the whole application/memory may not be used for something else such as read out while the program/erase is in progress. Methods to erase and program larger amounts of data at the same time may save time and power in the regular use of an application.

Techniques for programming and erasing include programming and erasing single pages, fixed blocks/sectors, or even complete memories in single or few cycles. Partial erase of a block or sector is possible via repetitive and lengthy single page erase actions, or via programming the data to be copied to another block sector, followed by a block/sector erase.

To overcome the repetitive page by page cycles, grouping of several pages is efficient. However, physically grouped blocks may not work. Data management does not necessarily require a row/page to be erased immediately when it is invalidated. A list of pages to be erased in the future or other book-keeping may be implemented. Such a list will be a small part of all the book-keeping required for data management. Once an erase cycle must be performed by any means, the other listed pages can be erased at the same time in the same erase cycle as a shadow erase. In this way all the listed rows may be erased without any timing penalty to be ready for the program cycle. Such a system would also allow a user to program multiple rows at once. The list or book-keeping aspect may be implemented outside the particular memory upon which the erase function will be performed.

The memory is configured to allow erasing of multiple independent rows at the same time belonging to different blocks. Selecting multiple independent rows at the same time may be difficult as a memory may only have one address bus for address selection. The selection is realized by selecting multiple rows after each other at the start of a program/erase sequence but before entering the high voltage part of the sequence. The system may include a defined sequence of control signals to define the adding and/or subtracting of page selections and the start of the erase/program operation. A dedicated latch per page may be used.

### Summary

Embodiments of a system to perform an erase operation on a memory device are disclosed. One embodiment of a system to perform an erase operation on a memory device includes a storage device and a flash memory device including a flash memory controller. The storage device is configured to store a list of multiple pages to be erased from a flash memory device. The list includes two or more independent pages residing on different erase blocks on the flash memory device. The flash memory is configured to select at least two or more independent pages on the list of multiple pages to be erased from the flash memory device and perform an erase operation erasing the selected at least two or more independent pages on the list of multiple pages to be erased from the flash memory device.

In some embodiments, the flash memory controller is further configured to receive an erase command to erase a page located on the flash memory device. In some embodiments, the flash memory controller is further configured to delay any erase operation to erase the page indicated by the erase command until reaching a threshold. In some embodiments, the flash memory controller is further configured to store an indicator in the list that the page is to be erased. In some embodiments, the flash memory controller is further configured to monitor the threshold. In some embodiments, the flash memory controller is further configured to select the two or more independent pages on the list of multiple pages to be erased from the flash memory device in response to reaching the threshold. In some embodiments, the flash memory controller is further configured to implement the erase operation erasing the selected pages in response to reaching the threshold. In some embodiments, the storage device is located outside of the flash memory device. In some embodiments, the storage device is located on the flash memory device. In some embodiments, each page within the flash memory device includes a dedicated separate latch. Each dedicated separate latch indicates whether a page is to be erased.

Embodiments of a method to perform an erase operation on a memory device are disclosed. One embodiment of a method to perform an erase operation on a memory device includes storing a list of multiple pages to be erased from the memory device, selecting at least two or more independent pages on the list of multiple pages to be erased from the memory device, and implementing an erase operation erasing the selected at least two or more independent pages on the list of multiple pages to be erased from the memory device. The list includes two or more independent pages residing on different erase blocks on the memory device. More than one page may reside on the same erase block.

In some embodiments, the method further includes receiving an erase command to erase a page located on the memory device. In some embodiments, the method further includes delaying any erase operation to erase the page indicated by the erase command until reaching a threshold. In some embodiments, the method further includes storing an indicator in the list that the page is to be erased. In some embodiments, the method further includes monitoring the threshold. In some embodiments, the method further includes selecting the at least two or more independent pages on the list of multiple pages to be erased from the memory device in response to reaching the threshold. In some embodiments, the method further includes implementing an erase operation erasing the selected at least two or more independent pages on the list of multiple pages to be erased from the memory device in response to reaching the threshold. In some embodiments, each page within the memory device includes a dedicated separate latch. Each dedicated separate latch indicates whether a page is to be erased.

Embodiments of a memory device configured to perform an erase operation are disclosed. The memory device includes a flash memory controller coupled to the memory device, the flash memory controller configured to select at least two or more independent pages on a list of multiple pages to be erased from the memory device, and perform an erase operation erasing the selected at least two or more independent pages on the list of multiple pages to be erased from the memory device. The two or more independent pages may reside on different erase blocks on the memory device.

In some embodiments, the flash memory controller is further configured to receive an erase command to erase a page located on the memory device. In some embodiments, the flash memory controller is further configured to delay any erase operation to erase the page indicated by the erase command until reaching a threshold. In some embodiments, the flash memory controller is further configured to store an indicator in the list that the page is to be erased. In some embodiments, the flash memory controller is further configured to monitor the threshold. In some embodiments, the flash memory controller is further configured to select the at least two or more independent pages on the list of multiple pages to be erased from the memory device in response to reaching the threshold. In some embodiments, the flash memory controller is further configured to perform the erase operation erasing the selected at least two or more independent pages on the list of multiple pages to be erased from the memory device in response to reaching the threshold.

Other aspects in accordance with the invention will become apparent from the following detailed description, taken in conjunction with the accompanying drawings, illustrated by way of example of the principles of the invention.

### Brief Description of the Drawings

Fig. 1 depicts a schematic diagram of one embodiment of a system to perform an erase operation on a memory device.
Fig. 2 depicts a schematic diagram of one embodiment of a memory device.
Fig. 3 depicts a schematic diagram of one embodiment of erase blocks of the memory device of Fig. 1 and the erase mapping register of Fig. 2.
Fig. 4 depicts a schematic diagram of one embodiment of erase blocks of the memory device of Fig. 1 with a separate dedicated latch for each page.
Fig. 5 depicts an embodiment of a method to perform an erase operation on a memory device.

Throughout the description, similar reference numbers may be used to identify similar elements.

### Detailed Description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment", "an embodiment", or similar language means that a particular feature, structure, or characteristic described in connection with the indicated embodiment is included in at least one embodiment of the present invention. Thus, the phrases "in one embodiment", "in an embodiment", and similar language throughout this specification may, but do not necessarily, all refer to the same embodiment.

Flash memory is a non-volatile electronic computer storage medium which may be electrically erased and reprogrammed. In many instances, the time required to erase data from a cell of a flash memory device is longer than the time to write data to a cell and may be significantly longer than the time to read data from a cell. Erase operations occur at large blocks (or segments) of memory cells. Read operations and program operations may typically occur in smaller segments than erase operations. In many instances, access to a chip or segment of a chip is blocked during performance of an erase operation. As a result a read or write operation may not be able to perform during an erase operation. Reducing the time of an erase operation or reducing the time for the erasing procedure may save time and power. In addition, implementing an erase procedure may take longer than the actual erase procedure itself. As flash memory devices get smaller the time delay associated with read/write/erase times increases. By grouping multiple page erase operations into a single procedure frees up time on a flash memory device for more read/write operations. In instances where read/write times are significantly shorter than erase times, waiting for erase operations to occur before implementing read/write operations can significantly increase the time for read/write operations.

As used herein, erase operation includes any operation to erase data represented by a state on a flash memory device. A flash memory device includes a memory array of memory elements, where each memory element is configured to store an electrical parameter (e.g., a charge, a voltage) to represent data.

While many embodiments are described herein, at least some of the described embodiments facilitate erasing multiple independent pages (i.e., from different blocks). Some embodiments allow for many advances that can save time and power, and reduce program/erase activity. Some embodiments allow the erasure of many independent pages at the same time in the background of erasing a single page. Some embodiments allow for managing erase operations and unburdening a flash memory device at specified times or durations. Some embodiments allow for delaying erase operations and grouping erase operations within a single procedure for optimization. Some embodiments enable tighter security of the data of memory devices. Some embodiments allow for scrambling of a logical sector randomly over a physical matrix and across different erase blocks while still being able to erase the full logical sector at the same time. Some embodiments allow for the scrambling of a logical sector on a die to die basis.

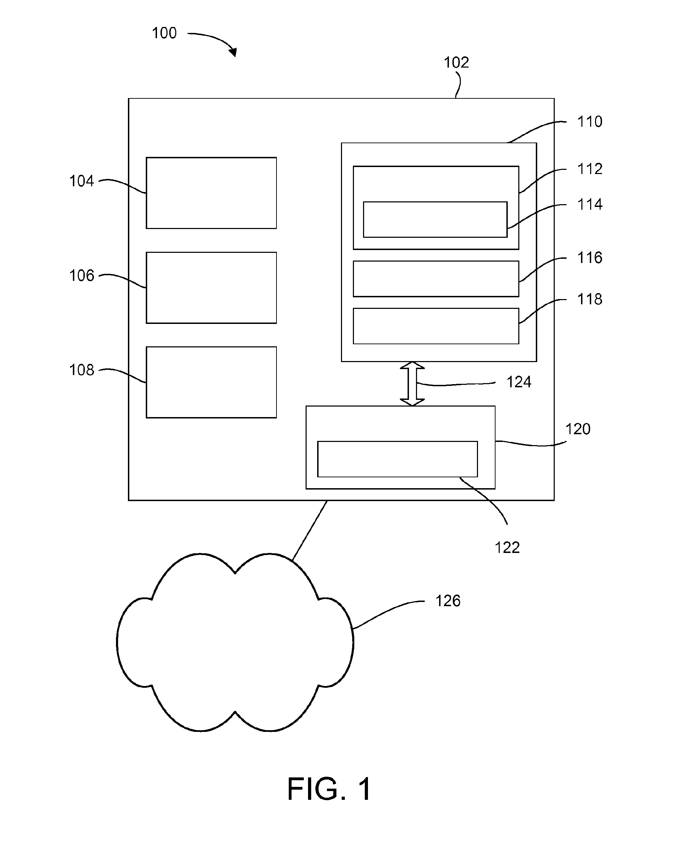

Fig. 1 depicts a schematic diagram of one embodiment of a system 100 to perform an erase operation on a memory device 120. Although the system 100 is shown and described with certain components and functionality, other embodiments of the system 100 may include fewer or more components to implement less or more functionality.

The depicted system 100 includes various components that are capable of performing the operations and functions described in more detail below. In some embodiments the components of the system 100 are implemented on a computing device 102. In some embodiments, the at least some of the components of the system 100 are implemented on a network 126. Additionally, the functions and operations may be executed on more than one computing device 102 connected over a network 126. The network 126 may be a wired, wireless, or another type communication network. In some embodiments, the system 100 may be used to implement any methods described in more detail herein.

The illustrated computing device 102 includes a processing unit or processor 104, input/output devices 106, a storage device 108, a controller 110, and a memory device 120. The memory device 120 may include non-volatile and volatile memory. In some embodiments, the memory device 120 is a flash memory device. In some embodiments, the memory device 120 is another type of non-volatile memory. The illustrated memory device 120 includes memory elements 122. In the illustrated embodiment, the controller 110 is configured to couple to the memory device 120 through an input/output interface 124. The controller 110 may be implemented by implementations capable of controlling operations in the memory device 120. Although the controller 110 is shown and described with certain components and functionality, other embodiments of the controller 110 may include fewer or more components to implement less or more functionality.

The illustrated controller 110 includes an erase module 112, a program module 116, and a data read module 118. The erase module 112 includes a threshold policy 114. The controller 110 may include fewer or more modular components in other embodiments. The components of the system 100 described herein may perform operations either separately or in conjunction with other components of the computing device 102, network 126, controller 110, and/or memory device 120.

In some embodiments, the erase module 112 erases data stored at memory elements 122 by issuing an instruction or command to the memory device 120. The erase module 112 may include more components to perform the operations described herein. The illustrated erase module 112 includes a threshold policy 114. In some embodiments, the erase module 112 may implement a mechanism to delay erase operations and implement erasing multiple independent pages residing on different erase blocks. The threshold policy 114 may include various thresholds or conditions that determine whether to delay an erase operation and when a multiple independent page erase operation should be implemented. The threshold policy may include various criteria, including but not limited to, the number of erase operations previously delayed, the amount of data to be erased, the number of read or write operations behind the erase operation, the priority of operations behind the erase operation, usage statistics of the memory elements, performance parameters of the computing device or memory device, user statistical analysis, a nominal increase in average read or write time, memory device characteristics, or the amount of free space on the memory device. In some embodiments, a specific row/page may be needed and may satisfy the threshold policy and implement an erase operation. The specific row/page may be needed for a program operation.

In some embodiments, the erase module 112 is configured to process the storing of information (an indicator, list, addresses, or other type of information) on pages to be erased. In some embodiments, the information is stored on storage 108 of the computing device 102. In some embodiments, the information is stored on the memory device 120 or on another component. In some embodiments, the information is stored on the network 126.

In some embodiments, the program module 116 programs bits of the memory elements 122 of the memory device 120 and may do so by issuing instructions to the memory device 120 to set memory elements 122 to a state that represents the data. In some embodiments, the data read module 118 reads data from the memory elements 122 by detecting the current state for memory elements 122 and determining the data represented by the state. The program module 116 and the data read module 118 may be implemented track average and specific read and write times for the memory device 120 and specific memory elements 122.

The memory device 120 includes one or more memory elements 122. In some embodiments, the memory device 120 may be a flash memory device or other type of electronically erasable programmable memory device, or combination thereof. The memory device 120 may include one or more dies, each with an array of memory elements 122 or memory array. In some embodiments the memory device 120 includes a single die with a memory array. In some embodiments, the memory device 120 may be an integrated circuit package or may include a common circuit board with a plurality of integrated circuit packages or chip array. The controller 110 may be mounted to the same circuit board as the chip array or located remotely from the circuit board with which the controller 110 communicates. The memory device 120 may store data associated with the computing device 102 or network 126. Some embodiments may include more than one memory device 120 located on a single computing device or multiple computing devices. The memory elements 122 may be single level cell flash elements or multi-level cell flash elements. In some embodiments, the memory elements 122 may be configured to operate in modes similar to those described herein. Although the functions and operations described in conjunction with Fig. 1 are implemented by various components on the computing device 102 and network 126, the functions and operations may be implemented wholly by the memory device 120.

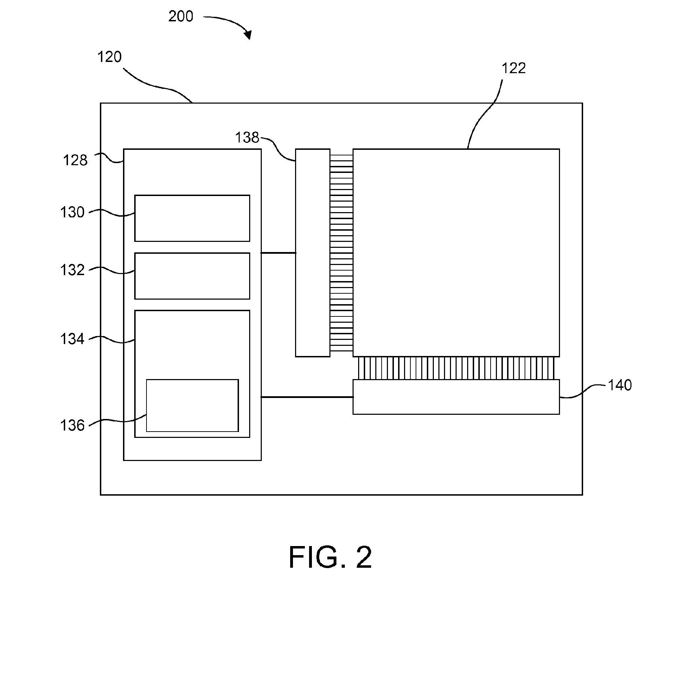

Fig. 2 depicts a schematic diagram 200 of one embodiment of a memory device 120. In some embodiments, the memory device 120 may be a flash memory device or other type of electronically erasable programmable memory device, or combination thereof. The illustrated memory device 120 includes memory elements 122, a memory controller 128, a row decoder 138, and a column decoder 144. Although the memory device 120 is shown and described with certain components and functionality, other embodiments of the memory device 120 may include fewer or more components to implement less or more functionality.

In some embodiments, the memory controller 128 controls read/write/erase operations at the memory elements 122. In some embodiments, the memory controller 128 may be a flash memory controller. The memory controller 128 may include some or all of the components described above in conjunction with the controller 110 of Fig. 1 to perform some or all of the functions and operations described in conjunction with the controller 110 and may include an erase module including threshold policy, program module, and data read module.

In some embodiments, the memory controller 128 may control the application of different voltage levels at the row decoder 138 and/or the column decoder 140 to perform various read/write/erase operations at some of the memory elements 122. Some embodiments may include multiple arrays of memory elements 122 controlled by a single memory controller 128. In such a case, each array may have corresponding row and column decoders. In some embodiments, signals from the controller 110 are transmitted to the memory device 120 including various select, read, write, erase, address, and other control signals. Data may be transmitted between the controller 110 and memory device 120 via a data bus or similar component(s). Some embodiments may use varying numbers or configurations of communication channels.

In some embodiments, the memory controller 128 may receive signals and commands (such as erase commands) from external sources including controller 110. In some embodiments, the memory controller 128 receives an erase command to erase a page(s) located on the memory device 120 and an address (or range of addresses) for the page(s). The memory controller 128 may store a command in the command register 130. Additionally, the memory controller 128 may store the address or addresses in an address register 132.

The illustrated embodiment includes an erase mapping register 134 including a threshold manager 136. The erase mapping register 134 may delay any erase operation to erase a page(s) indicated by an erase command. The erase mapping register 134 may delay the erase operation until the satisfaction of specified conditions or the reaching of a threshold as dictated by the threshold manager 136. Additionally, the erase mapping register 134 may store pertinent information regarding page(s) to be erased until the erase operation is implemented. The erase mapping register 134 may store a list of pages to be erased. In some embodiments, the erase mapping register 134 is configured to process the storing of information (an indicator, list, addresses, or other type of information) on pages to be erased. In some embodiments, the information is stored on a separate storage device (such as store device 108 of the computing device 102). In some embodiments, the information is stored on the memory device 120 within the memory elements 122 or on another separate component. In some embodiments, the information is stored on a network (such as network 126).

In some embodiments, the erase mapping register 134 is configured to monitor a threshold or other condition that should be satisfied before performing an erase operation. In some embodiments, the erase mapping register 134 is configured to select at least two or more independent pages (i.e., residing on different blocks) from a list of multiple pages to be erased from the memory device 120 in response to reaching a threshold or other condition. In some embodiments, all the pages in the list are selected. In some embodiments, only a portion of the pages in the list are selected. The erase mapping register 134 may use various criteria to determine the number or amount of pages to be selected. The decoders 138-140 are configured to allow for selection of more than one independent page.

In some embodiments, the erase mapping register 134 is configured to implement an erase operation erasing the selected independent pages on the list of pages to be erased. In some embodiments, the erase mapping register 134 is configured to implement an erase operation in response to reaching a threshold or satisfaction of another condition.

The threshold manager 136 may manage the thresholds or conditions that may be necessary before implementing an erase operation. The threshold manager 136 may perform the same or similar operations to those described here in regards to the threshold policy 114. The threshold manager 136 may include various thresholds or conditions that determine whether to delay an erase operation and when an independent page erase operation should be implemented. The threshold policy may include various criteria, including but not limited to, the number of erase operations previously delayed, the amount of data to be erased, the number of read or write operations behind the erase operation, the priority of operations behind the erase operation, usage statistics of the memory elements, performance parameters of the computing device or memory device, user statistical analysis, a nominal increase in average read or write time, memory device characteristics, or the amount of free space on the memory device.

In some embodiments, the memory device 120 may be a flash memory device or other type of electronically erasable programmable memory device, or combination thereof. The memory device 120 may include one or more dies, each with an array of memory elements 122 or memory array. In some embodiments the memory device 120 includes a single die with a memory array. In some embodiments, the memory device 120 may be an integrated circuit package or may include a common circuit board with a plurality of integrated circuit packages or chip array. The memory elements 122 may be single level cell flash elements or multi-level cell flash elements. In some embodiments, the memory elements 122 may be configured to operate in modes similar to those described herein. Although the functions and operations described in conjunction with Fig. 2 are implemented by various components on the memory device 120, the functions and operations may be implemented on a network 126 or separate computing device.

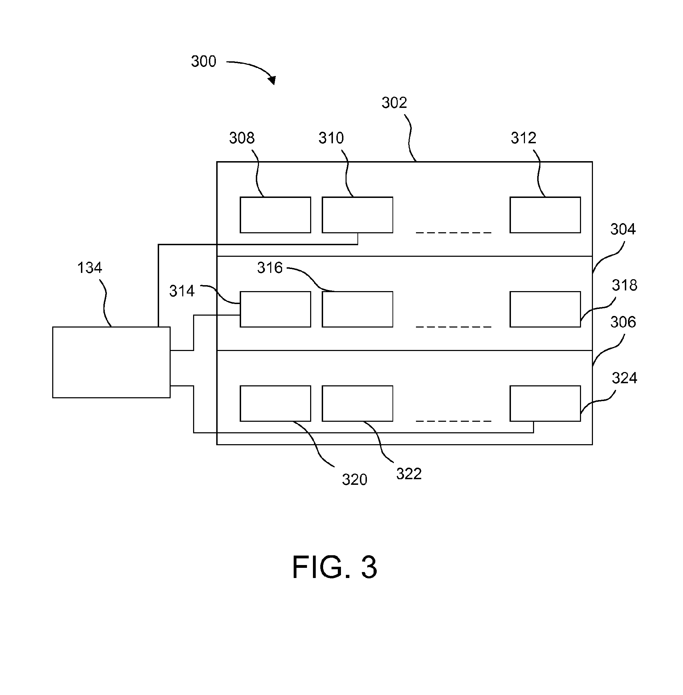

Fig. 3 depicts a schematic diagram 300 of one embodiment of erase blocks 302-306 of the memory device 120 of Figs. 1 and 2 with the erase mapping register of Fig. 2. The illustrated embodiment includes erase block 1 302, erase block 2 304, and erase block 3 306. Each erase block includes various pages. Erase block 1 302 includes page 1 308, page 2 310, page n 312, and intervening pages (not shown). Similarly, erase block 2 304 includes page 1 314, page 2 316, page n 318, and intervening pages (not shown). Erase block 3 306 includes page 1 320, page 2 322, page n 324, and intervening pages (not shown). Embodiments may include varying numbers of blocks and varying number of pages within a particular block or blocks. In some embodiments, the erase mapping register 134 (or other component of memory controller 128) may select pages for erasure from across various blocks. In the illustrated embodiment, the erase mapping register 134 has selected page 2 310 of block 1 302, page 1 314 of block 2 304, and page n 324 of block 3 306.

In some embodiments, the erase mapping register 134 may store a list of multiple independent pages to be erased. The pages may be located in different blocks 302-306. In some embodiments, the erase mapping register 134 is configured to process the storing of information (an indicator, list, addresses, or other type of information) on independent pages to be erased and may store the information until the erase operation is implemented. The information may be stored on a separate storage device, on the memory device 120, within the memory elements 122, or on another separate component or network.

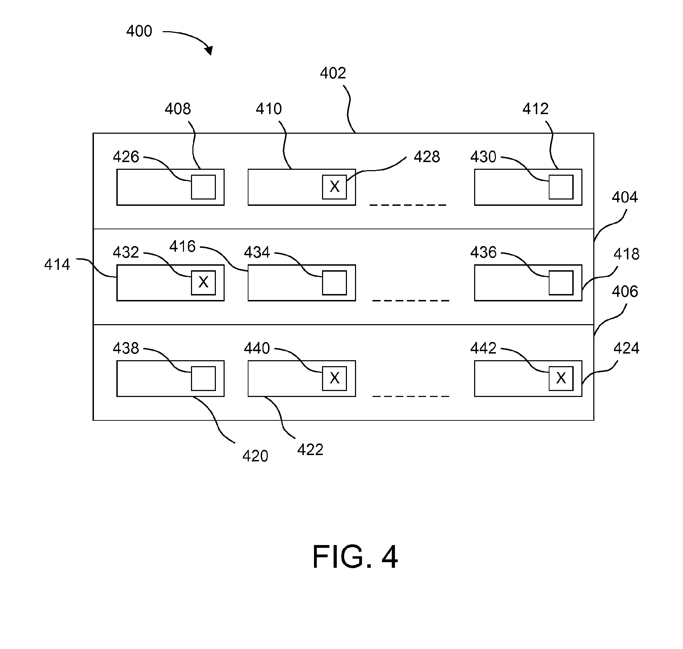

Fig. 4 depicts a schematic diagram of one embodiment of erase blocks 402-406 of the memory device 120 of Figs. 1 and 2 with a separate dedicated latch 426-442 for each page 408-424 to indicate the pages to be erased. In some embodiments a separate list of pages to be erased is stored on the memory device 120 or computing device 102. In the illustrated embodiment, pages to be erased are listed by way of a dedicated latch for each page indicating whether the page is to be erased upon the implementation of an erase operation.

The illustrated embodiment includes erase block 1 402, erase block 2 404, and erase block 3 406. Each erase block includes various pages. Erase block 1 402 includes page 1 408, page 2 410, page n 412, and intervening pages (not shown). Similarly, erase block 2 404 includes page 1414, page 2 416, page n 418, and intervening pages (not shown). Erase block 3 406 includes page 1 420, page 2 422, page n 424, and intervening pages (not shown). Embodiments may include varying numbers of blocks and varying number of pages within a particular block or blocks. Each page 408-424 includes a dedicated latch to indicate whether a page is to be erased. For block 1 402, page 1 408 includes latch 426, page 2 410 includes latch 428, and page n 412 includes latch 430. For block 2 404, page 1 414 includes latch 432, page 2 416 includes latch 434, and page n 418 includes latch 436. For block 3 406, page 1 420 includes latch 438, page 2 422 includes latch 440, and page n 424 includes latch 442. In the illustrated embodiment, latches 428, 432, 440, and 442 indicate that page 2 410 of block 1 402, page 1414 of block 2 404, page 2 422 of block 3 406, and page n 424 of block 3 406 are listed to be erased.

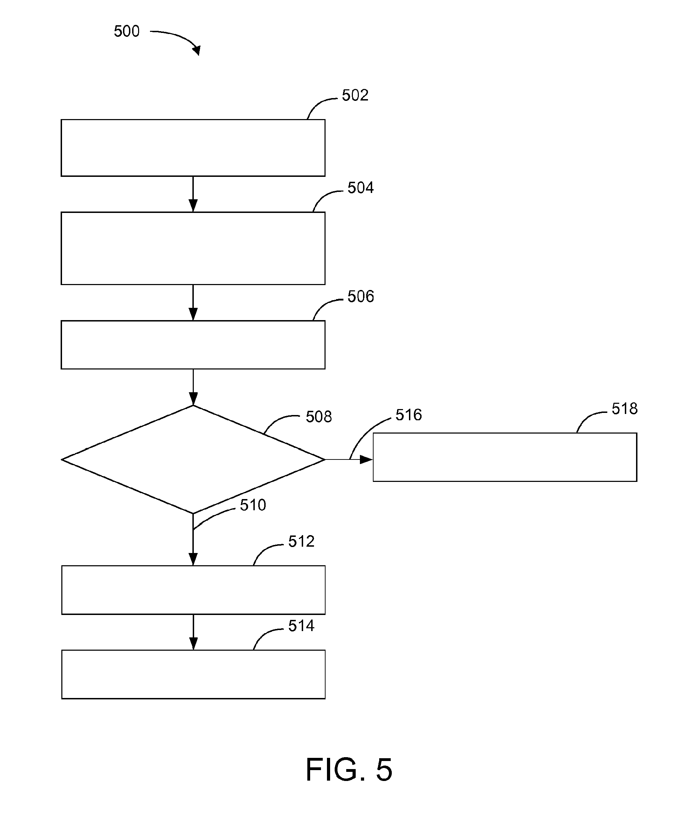

The separate dedicated latch 426-442 for each page 408-424 may also allow for the selection of multiple independent pages. Selecting multiple independent rows at the same time may be difficult with only address bus for address selection. Embodiments allow for the selection of independently selected pages (410, 414, 422, and 424) that can keep their selected status while other pages are being selected. Row selection logic can be configured to allow for multiple independent page selection. This allows for the selection of multiple independent pages before entering the high voltage portion of an erase operation. Low voltage inputs to select and deselect may be used before the high voltage portion of an erase operation. A dedicated row decoder design may be used to implement multiple row selection. In one example (without limitation), latching functionality may be implemented inside the high voltage part of a driver, as the driver may need feedback signals equivalent to a simple level shifter. A high voltage control gate driver applies the correct voltages to program and erase and may include a high voltage latch and drives with low voltage inputs to select and deselect, which are shielded via high voltage isolation devices. The shielding devices are connected to the same control signal and the latch is continuously forced into a certain state via one of the low voltage inputs. The latching properties are only exercised during the high voltage state when the isolation is active. Control of the isolation devices has been separated. During high voltage phase, high voltage is isolated from low voltage. During the low voltage phase (selection phase), the isolating devices have a second function. At the start of an erase/program sequence all rows are deselected, then the isolation devices isolate the latch from the input signals and all latches stay unselected, after which the address decoder can point to the first address to be selected. Now only the required isolation device is set to conducting state so that out of all pages only the selected page is selected and latched, after which the isolation is activated again. By blocking the opposite isolation device continuously de-selection of the selected page cannot occur. The procedure may be repeated for any other page allowing the selection of multiple independent pages. Other procedures and schemes are envisioned to allow for the selection of multiple independent pages. In another example, isolation devices are used to allow selection of latches (determined by the address applied) without deselecting any already selected latches. Fig. 5 depicts a flow chart diagram of an embodiment of a method 500 to perform an erase operation on a memory device 120. Although the method 500 is described in conjunction computing device and memory device of Figs. 1-4, embodiments of the method 500 may be implemented with other types of computer systems.

At 502, an erase command is received from a controller 110 to erase a page 410 located on memory device 120. At 504, any erase operation to erase the page 410 is delayed. At 506, an indicator is stored indicating that the page 410 is to be erased. At 508, a threshold is monitored and a decision is made. If the threshold has been met 510 then at 512, multiple independent pages are selected to be erased, where the independent pages reside on different blocks 402, 404. At 514, an erase operation is implemented of the selected independent pages. Returning to 508, if the threshold has not been met 516 then, at 518, the erase operation is delayed.

Other embodiments of the method 500 may include fewer or more steps to implement less or more functionality. Other embodiments of the method 500 may include some or all the operations and steps as described above in conjunction with Figs. 1-4 in various combinations and are not expounded upon for the sake of brevity.

An embodiment of a flash memory device controller or memory device controller includes at least one processor coupled directly or indirectly to memory elements through a system bus such as a data, address, and/or control bus. The memory elements can include local memory employed during actual execution of the program code, bulk storage, and cache memories which provide temporary storage of at least some program code in order to reduce the number of times code must be retrieved from bulk storage during execution.

It should also be noted that at least some of the operations for the methods may be implemented using software instructions stored on a computer useable storage medium for execution by a computer. As an example, an embodiment of a computer program product includes a computer useable storage medium to store a computer readable program that, when executed on a computer, causes the computer to perform operations, as described herein.

Embodiments of the invention can take the form of an entirely hardware embodiment, an entirely software embodiment, or an embodiment containing both hardware and software elements. In one embodiment, the invention is implemented in software, which includes but is not limited to firmware, resident software, microcode, etc.

Furthermore, embodiments of the invention can take the form of a computer program product accessible from a computer-usable or computer-readable medium providing program code for use by or in connection with a computer or any instruction execution system. For the purposes of this description, a computer-usable or computer readable medium can be any apparatus that can contain, store, communicate, propagate, or transport the program for use by or in connection with the instruction execution system, apparatus, or device.

The computer-useable or computer-readable medium can be an electronic, magnetic, optical, electromagnetic, infrared, or semiconductor system (or apparatus or device), or a propagation medium. Examples of a computer-readable medium include a semiconductor or solid state memory, magnetic tape, a removable computer diskette, a random access memory (RAM), a read-only memory (ROM), a rigid magnetic disk, and an optical disk. Current examples of optical disks include a compact disk with read only memory (CD-ROM), a compact disk with read/write (CD-R/W), and a digital video disk (DVD).

Input/output or I/O devices (including but not limited to keyboards, displays, pointing devices, etc.) can be coupled to the system either directly or through intervening I/O controllers. Additionally, network adapters also may be coupled to the system to enable the data processing system to become coupled to other data processing systems or remote printers or memory devices through intervening private or public networks. Modems, cable modems, and Ethernet cards are just a few of the currently available types of network adapters.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

The present disclosure extends to the following series of lettered clauses: (A) A memory device configured to perform an erase operation, the memory device comprising: a flash memory controller coupled to the memory device, the flash memory controller configured to: select at least two or more independent pages on a list of multiple pages to be erased from the memory device, wherein the two or more independent pages reside on different erase blocks on the memory device; and perform an erase operation erasing the selected at least two or more independent pages on the list of multiple pages to be erased from the memory device; (B) the memory device of clause (A), wherein the flash memory controller is further configured to: receive an erase command to erase a page located on the memory device; delay any erase operation to erase the page indicated by the erase command until reaching a threshold; store an indicator in the list that the page is to be erased; monitor the threshold; and select the at least two or more independent pages on the list of multiple pages to be erased from the memory device in response to reaching the threshold; (C) the memory device of clause (B), wherein the reaching the threshold comprises reaching a defined number of bytes in the list; (D) the memory device of clause (B), wherein each page within the memory device comprises a latch, wherein the latch indicates whether a page is to be erased; (E) the memory device of clause (B), wherein the reaching the threshold comprises reaching a defined number delayed erase operations; (F) the memory device of clause (A), wherein each page within the memory device comprises a latch, wherein the latch indicates whether a page is to be erased.

In the above description, specific details of various embodiments are provided. However, some embodiments may be practiced with less than all of these specific details. In other instances, certain methods, procedures, components, structures, and/or functions are described in no more detail than to enable the various embodiments of the invention, for the sake of brevity and clarity.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. A system to perform an erase operation on a memory device, the system comprising:
a storage device configured to store a list of multiple pages to be erased from a flash memory device, wherein the list comprises two or more independent pages residing on different erase blocks on the flash memory device; and
the flash memory device comprising a flash memory controller coupled to the flash memory device, the flash memory controller configured to:
select at least two or more independent pages on the list of multiple pages to be erased from the flash memory device; and
implement an erase operation erasing the selected at least two or more independent pages on the list of multiple pages to be erased from the flash memory device.

2. The system to perform an erase operation on a memory device of claim 1, wherein the flash memory controller is further configured to:
receive an erase command to erase a page located on the flash memory device;
delay any erase operation to erase the page indicated by the erase command until reaching a threshold;
store an indicator in the list that the page is to be erased;
monitor the threshold;
select the at least two or more independent pages on the list of multiple pages to be erased from the flash memory device in response to reaching the threshold.

3. The system to perform an erase operation on a memory device of any of claim 1 or claim 2, wherein the storage device is located outside of the flash memory device.

4. The system to perform an erase operation on a memory device of any of claim 1 or claim 2, wherein the storage device is located on the flash memory device.

5. The system to perform an erase operation on a memory device of any of claim 2, 3, or 4, wherein the reaching the threshold comprises reaching a defined number of bytes in the list.

6. The system to perform an erase operation on a memory device of any of claim 1, 2, 3, 4, or 5, wherein each page within the flash memory device comprises a dedicated separate latch, wherein each dedicated separate latch indicates whether a page is to be erased.

7. The system to perform an erase operation on a memory device of any of claim 2, 3, 4, or 6, wherein the reaching the threshold comprises reaching a defined number delayed erase operations.

8. The system to perform an erase operation on a memory device of any of claim 2, 3, 4, or 6, wherein the reaching the threshold comprises a nominal increase in average write time on the flash memory device.

9. A method to perform an erase operation on a memory device, the method comprising:
storing a list of multiple pages to be erased from the memory device, wherein the list comprises two or more independent pages residing on different erase blocks on the memory device;
selecting at least two or more independent pages on the list of multiple pages to be erased from the memory device; and
implementing an erase operation erasing the selected at least two or more independent pages on the list of multiple pages to be erased from the memory device.

10. The method to perform an erase operation on a memory device as claimed in claim 9, the method further comprising:
receiving an erase command to erase a page located on the memory device;
delaying any erase operation to erase the page indicated by the erase command until reaching a threshold;
storing an indicator in the list that the page is to be erased;
monitoring the threshold;
selecting the at least two or more independent pages on the list of multiple pages to be erased from the memory device in response to reaching the threshold.

11. The method to perform an erase operation on a memory device as claimed in any of claim 9 or claim 10, wherein the reaching the threshold comprises reaching a defined number of bytes in the list.

12. The method to perform an erase operation on a memory device as claimed in any of claim 9, claim 10, or claim 11, the method further comprising storing the list outside of the memory device.

13. The method to perform an erase operation on a memory device as claimed in any of claim 9, claim 10, or claim 11, the method further comprising storing the list on the memory device.

14. The method to perform an erase operation on a memory device as claimed in any of claim 9, claim 10, claim 12, or claim 13, wherein the reaching the threshold comprises reaching a defined number delayed erase operations.

15. The method to perform an erase operation on a memory device as claimed in any of claim 9, claim 10, claim 12, or claim 13, wherein the reaching the threshold comprises a nominal increase in average write time on the flash memory device.
